**Europäisches Patentamt**

**European Patent Office**

**Office européen des brevets**

(19)

(11) Veröffentlichungsnummer : **0 135 163**
**B1**

(12) **EUROPÄISCHE PATENTSCHRIFT**

(45) Veröffentlichungstag der Patentschrift :
04.05.88

(21) Anmeldenummer : 84109901.3

(22) Anmeldetag : 20.08.84

(51) Int. Cl.⁴ : **H 01 L 21/82, H 01 L 21/285,**
**H 01 L 27/08, H 01 L 29/62**

(54) Verfahren zum Herstellen von hochintegrierten komplementären MOS-Feldeffekttransistorschaltungen.

(30) Priorität : 26.08.83 DE 3330851

(43) Veröffentlichungstag der Anmeldung :
27.03.85 Patentblatt 85/13

(45) Bekanntmachung des Hinweises auf die Patenterteilung : 04.05.88 Patentblatt 88/18

(84) Benannte Vertragsstaaten :
AT CH DE FR GB IT LI NL SE

(56) Entgegenhaltungen :
DE-A- 2 700 873
DE-A- 2 740 549
DE-A- 3 149 185
US-A- 4 151 537
US-A- 4 217 149
US-A- 4 385 947
IEEE TRANSACTIONS ON ELECTRON DEVICES,
Band ED-27, Nr. 8, August 1980, Seiten 1409-1417,
IEEE, New York, USA; S.P. MURARKA et al.: "Refractory silicides of titanium and tantalum for low-resistivity gates and interconnects"
IEEE TRANSACTIONS ON ELECTRON DEVICES,
Band ED-27, Nr. 9, September 1980, Seiten 1789-1795,
IEEE, New York, USA; T. OHZONE et al.: "Silicon-gate n-well CMOS process by full ion-implantation technology"
IEEE Transactions on Electron Devices, Vol. ED-27,
August 1980, Seiten 1409-1417
Die Akte enthält technische Angaben, die nach dem Eingang der Anmeldung eingereicht wurden und die nicht in dieser Patentschrift enthalten sind.

(73) Patentinhaber : Siemens Aktiengesellschaft Berlin
und München
Wittelsbacherplatz 2
D-8000 München 2 (DE)

(72) Erfinder : Schwabe, Ulrich, Dr.
Plivierpark 14
D-8000 München 83 (DE)
Erfinder : Jacobs, Erwin P., Dr.
Stieglitzweg 9b
D-8011 Vaterstetten (DE)
Erfinder : Neppl, Franz, Dr.
St. Quirin-Platz 6
D-8000 München 90 (DE)

# Beschreibung

Die Erfindung betrifft ein Verfahren zum Herstellen von hochintegrierten komplementären MOS-Feldeffekttransistorschaltungen (CMOS-Schaltungen), bei dem für die Aufnahme der n- bzw. p-Kanaltransistoren der Schaltung im Halbleitersubstrat p- bzw. n-dotierte Wannen erzeugt werden, in welche zur Einstellung der verschiedenen Transistoreinsatzspannungen die entsprechenden Dotierstoffatome durch Ionenimplantationen eingebracht werden, wobei die Maskierung für die einzelnen Ionenimplantationen durch Fotolack- und/oder durch Siliziumoxid- bzw. Siliziumnitrid-Strukturen erfolgt und bei dem die Herstellung der Source/Drain- und Gatebereiche sowie die Erzeugung des Zwischen- und Isolationsoxids und der Leiterbahnebene nach bekannten Verfahrensschritten der MOS-Technologie vorgenommen wird.

Die Aufgabe, die der vorliegenden Erfindung zugrundeliegt, besteht in der Durchführung eines CMOS-Prozesses, bei dem die symmetrische Einstellung der Einsatzspannung von n- und p-Kanaltransistoren mit dünnen Gateoxiden durch eine einzige Kanalimplantation unter Einsparung einer fotolithographischen Maske vorgenommen werden kann.

Moderne CMOS-Prozesse verwenden Technologien, bei denen sowohl n- als auch p-Kanaltransistoren in Wannen liegen. Die Einstellung der verschiedenen Transistor-Einsatzspannungen (Dünnoxidtransistoren und Feldoxidtransistoren beider Typen) erfolgt durch mehrfache, aufeinander abgestimmte Ionenimplantationen.

So ist aus einem Aufsatz von L. C. Parillo et al aus dem Techn. Dig. IEDM 1980, 29.1, Seiten 752-755, bekannt, die beiden n- bzw. p-dotierten Wannen in einem CMOS-Prozeß mittels selbstjustierender Prozeßschritte unter Verwendung nur einer Maske herzustellen. Die selbstjustierende Implantation der beiden Wannen führt bei der üblichen Eindringtiefe von 5 $\mu$m (p- und n-Wanne) an der Implantationskante zu einer starken räumlichen Überlappung und ladungsmäßigen Kompensation der n- bzw. p-implantierten Gebiete. Eine negative Folge davon ist, daß die Einsatzspannung des Feldoxidtransistors reduziert wird und die Stromverstärkung der parasitären npn- und pnp-Bipolartransistoren erhöht wird, was zu einer Vergrößerten « latch up »-Anfälligkeit (das ist die Zündwahrscheinlichkeit des parasitären Thyristors) führt.

Ein anderes Verfahren, welches sowohl die beiden Wannenals auch die Kanal- und Feldimplantation unter Verwendung getrennter Masken durchführt, ist aus einem Aufsatz von Y. Sakai et al aus dem Jap. J. Appl. Phys. 18, Suppl. 18-1, Seiten 73-78, zu entnehmen. Der Nachteil dieses Verfahrens ist, daß, bedingt durch die Anzahl der benötigten Maskenschritte der an und für sich schon in Bezug auf die Ausbeute kritische CMOS-Fertigungsprozeß sehr belastet wird.

Aus der DE-OS-3 149 185 ist ein CMOS-Prozeß zu entnehmen, bei dem zur Vermeidung einer starken räumlichen Überlappung an der Implantationskante der beiden n- bzw. p-dotierten Wannengebiete die p-Wanne vor der n-Wanne implantiert wird und tiefer als die n-Wanne eindiffundiert wird. Die n-Wanne weist nur eine geringe Eindringtiefe auf. Bei diesem Verfahren wird durch eine einzige Kanalimplantation die Transistor-Einsatzspannung für beide Transistortypen simultan eingestellt. Die Gateoxiddicke $d_{GOX}$ liegt im Bereich von 40 nm und beschränkt das Verfahren auf diesen relativ kleinen Gateoxiddickenbereich. Bein Übergang zu dünneren Gateoxiddicken ergeben sich bei gleichbleibenden Materialparametern niedrigere Einsatzspannungen. Soll die Einsatzspannung konstant gehalten werden, so ist entweder eine höhere Dotierung des Grundmaterials im Kanalbereich oder eine Änderung des Gatematerials erforderlich. In den meisten Fällen wird bei einer gleichzeitigen Dotierung der Kanalgebiete von n- und p-Kanaltransistoren die Einsatzspannung des einen Transistortyps angehoben, die des anderen Typs jedoch abgesenkt.

Die Erfindung löst die eingangs gestellte Aufgabe der symmetrischen Einstellung der Einsatzspannung der beiden n- und p-Kanaltransistoren mit Gateoxiddicken < 40 nm durch eine einzige Kanalimplantation in der Weise, daß

a) als Gatematerial ein hochschmelzendes Metall oder ein Metallsilizid verwendet wird, dessen Austrittsarbeitsdifferenz $\emptyset_{MS}$ zu n-Silizium im Vergleich zum bekannten $n^+$-Polysilizium-Gatematerial höher ist, wobei $\emptyset_{MS}$ an die Gateoxiddicke $d_{GOX}$ angepaßt ist,

b) die Gateoxiddicke $d_{GOX}$ auf Werte im Bereich von 10 bis 30 nm eingestellt wird und

c) für p- und n-Kanaltransistoren eine einzige gemeinsame Kanalimplantation durchgeführt wird, die so abgestimmt ist, daß bei gegebener Gateoxiddicke $d_{GOX}$ die Einsatzspannungen von n- und p-Kanaltransistoren symmetrisch sind und einen vorgegebenen Wert haben.

Dies ist möglich, da der kompensierte p-Kanaltransistor im Doppelwannen-CMOS-Prozeß infolge seiner Ladungsneutralität im Kanalbereich eine nur unwesentliche Gateoxiddickenabhängigkeit zeigt. In Abstimmung mit der Dotierung der beiden Wannen kann die Kanalimplantation so eingestellt werden, daß symmetrische Einsatzspannungen für n- und p-Kanaltransistoren resultieren.

Die Erfindung geht dabei von der Erkenntnis aus, daß die Einsatzspannung $U_T$ eines MOS-Transistors wesentlich durch die Austrittsarbeitsdifferenz $\emptyset_{MS}$ von Grund- und Gatematerial und durch die Gateoxiddicke bestimnt wird. Im Normalfall wird die Einsatzspannung bei gleichbleibendem Gatematerial und konstanter Oxiddicke durch eine Änderung der Grundmaterialkonzentration infolge einer gezielten Kanalimplantation eingestellt.

Durch die Möglichkeit in der Durchführung nur einer einzigen Kanalinplantation nach der Lehre der Erfindung wird prozeßtechnisch eine fotolithographische Maske eingespart, was eine wesentliche Verbesserung in Bezug auf Ausbeute und Kosten darstellt. Als weiterer Vorteil des Verfahrens nach der Lehre der Erfindung ergeben sich verringerte Unterschwellenströme für kurze Kanallängen ($< 0,5 \mu m$) und somit eine hohe Spannungsfestigkeit, da die Dosis der Kanalimplantation gering gehalten werden kann.

In einer Weiterbildung des Erfindungsgedankens ist vorgesehen, als Gatematerial die Silizide der Metalle Tantal, Titan, Molybdän oder Wolfram zu verwenden. Dabei wird das Gatematerial so ausgewählt, daß seine Austrittsarbeitsdifferenz an die Gateoxiddicke $d_{gox}$ angepaßt ist.

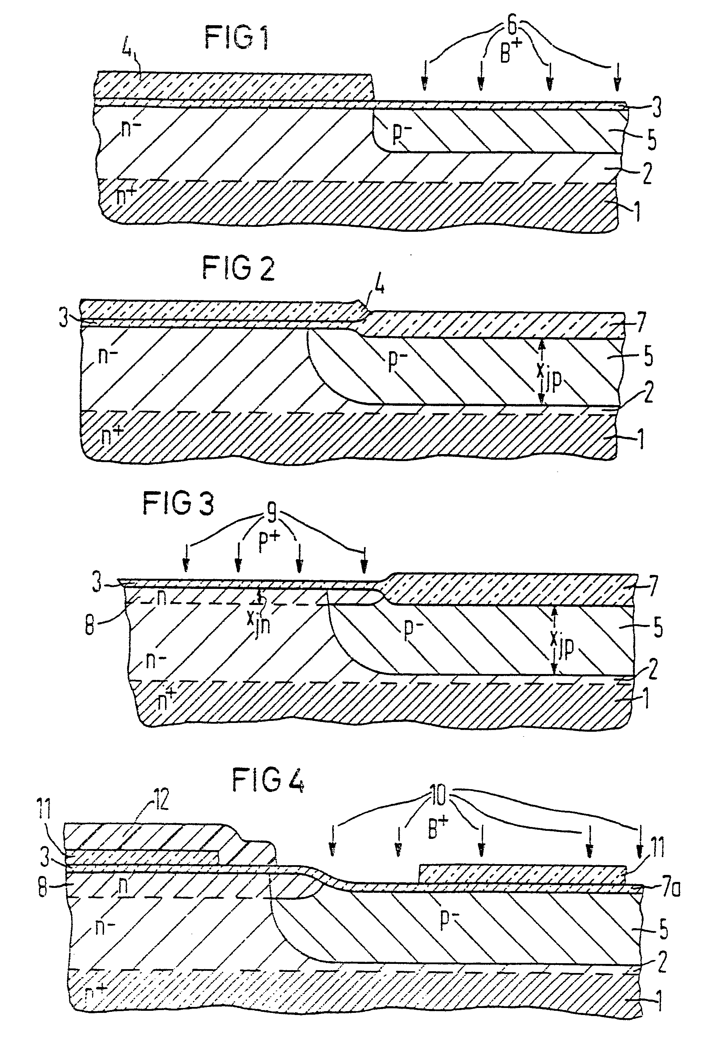

Im nachfolgenden wird anhand der Figuren 1 bis 7 ein CMOS-Prozeß unter Verwendung von Tantalsilizid ($TaSi_2$) als Gatematerial und einer Gateoxiddicke von 20 nm näher beschrieben.

Die Figuren 1 bis 7 zeigen im Schnittbild die durch die einzelnen Verfahrensschritte erzielten Strukturen, wobei der Einfachheit halber in jeder Figur mehrere Prozeßfolgen dargestellt sind.

In allen Figuren gelten für gleiche Teile gleiche Bezugszeichen.

Figur 1 : Zu Beginn der Prozeßfolge wird die p-Wanne (5) hergestellt. Dabei wird von einem, mit einer n-dotierten Epitaxieschicht 2 ($< 100 >$-Si, 20 Ohm cm) versehenen, $n^+$-dotierten Substrat 1 ($< 100 >$-Si, 0,01 bis 0,02 Ohm cm) ausgegangen, welches mit einer Oxidschicht 3 (50 nm) und mit einer, mit Hilfe einer Fotolacktechnik (nicht abgebildet) strukturierten Siliziumnitridschicht 4 von 140 nm Dicke versehen ist. Die Bor-Ionen-Implantation 6 zur Erzeugung der p-Wanne erfolgt mit einer Dosis und Energie von $1,5 \times 10^{12}$ cm$^{-2}$ und 160 keV.

Figur 2 : Nach dem Ablösen der Oxidschicht 3, wobei gezielt eine Unterätzung der Siliziumnitridschicht 4 durchgeführt wird, erfolgt ein Oxidationsprozeß. Die neu erzeugte Oxidschicht ist mit 7 bezeichnet und weist eine Dicke von 500 nm auf. In einem nachfolgenden Diffusionsprozeß werden die Bor-Ionen bis zu einer Eindringtiefe $x_{jp}$ von 6 $\mu m$ in die Epitaxieschicht 2 eindiffundiert. Die Dicke der Epitaxieschicht 2 beträgt 7 $\mu m$.

Figur 3 : Die Siliziumnitridschicht 4 wird entfernt. Die Herstellung der n-Wanne 8 erfolgt durch eine ganzflächige Phosphor-Ionen-Implantation 9 mit einer Implantationsdosis und Energie von $7 \times 10^{11}$ cm$^{-2}$ und 160 keV und anschließende Eindiffusion bis zu einer Eindringtiefe $x_{jn}$ von 1 bis 1,5 $\mu m$. Infolge der hohen Implantationsdosis kann die Feldionenimplantation für die Einstellung der Einsatzspannung der p-Kanaldickoxid-Transistoren und damit eine zusätzliche Maske eingespart werden.

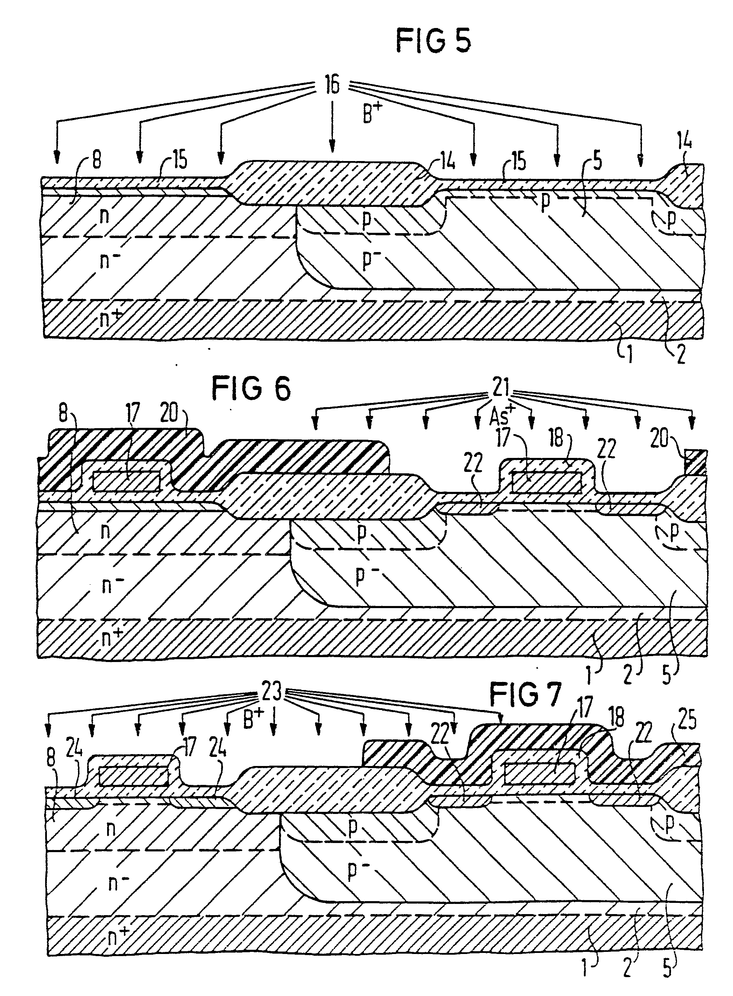

Figur 4 : Nach dem Eintreiben der Phosphor-Ionen für die n-Wanne 8 wird die Oxidschicht abgeätzt und es folgen die Oxidation der Schicht 7a (50 nm) und die Siliziumnitridabscheidung 11 in einer Schichtdicke von 120 nm und die Strukturierung der Siliziumnitridschicht (Maske LOCOS).

Die Feldimplantation der p-Wanne 5 mit Bor-Ionen erfolgt nach Maskierung der n-Wanne 8 und des gesamten Transistorbereichs der n-Kanal-Transistoren in der p-Wanne 5 mit der Siliziumnitridschicht 11. Alle Bereiche außer den p-Wannenbereichen werden während der Bor-Ionen-Implantation 10 mit einer Fotolackstruktur 12 abgedeckt. Die Implantationsdosis und Energie der Bor-Ionen-Implantation 10 wird auf $1,2 \times 10^{13}$ cm$^{-2}$ und 25 keV eingestellt.

Figur 5 : Nach Entfernung der Fotolackstruktur 12 werden dann unter Verwendung der Siliziumnitridschicht 11 als Maskierung die Feldoxidbereiche 14 in einer Schichtdicke von 1 000 nm durch lokale Oxidation erzeugt. Nach Ablösung der Siliziumnitridschicht 11 erfolgt eine thermische Oxidation der gesamten Oberfläche, wobei die Dicke der Gateoxidschicht 15 mit 20 nm (kleiner als bei üblichen CMOS-Prozessen) eingestellt wird. Dann erfolgt eine ganzflächige Bor-Ionen-Implantation 16 zur Dotierung des p- und n-Kanals, wobei die Implantationsdosis in Abstimmung mit den anderen Implantationen, der Gateoxiddicke und der Austrittsarbeit des aus Tantalsilizid bestehenden Gatematerials so eingestellt wird, daß für den n- und den p-Kanaltransistor eine symmetrische Einspannung $U_T$ erreicht wird. Im Ausführungsbeispiel wird die Implantationsdosis und Energie auf $3 \times 10^{11}$ Bor cm$^{-2}$ und 25 keV eingestellt, was bei Kanallängen $> 3 \mu m$ einer Einsatzspannung ($U_T$) = 0,7 V entspricht. Da die Ionenimplantation ganzflächig erfolgt, wird im Gegensatz zu anderen CMOS-Prozessen keine Maske benötigt.

Figur 6 : Es erfolgt nun die Abscheidung der Tantalsilizidschicht in einer Schichtdicke von 300 nm und ihre Strukturierung, wobei die Gatebereiche 17 erzeugt werden. Dann wird die gesamte Oberfläche mit einer Oxidschicht 18 bedeckt.

Diese Oxidabscheidung wird so geführt, daß die Oxidschichtdicke über den Source/Drain-Bereichen der n-Kanal-Transistoren in der p-Wanne 5 die spätere Source/Drain-Implantation nicht maskiert. Nach erfolgtem Aufbringen einer Fotolackstruktur 20, welche die Bereiche der p-Kanal-Transistoren in der n-Wanne 8 bedeckt, wird die Arsen-Ionen-Implantation 21 mit einer Dosis von $6 \times 10^{15}$ cm$^{-2}$ und einer Energie von 80 keV durchgeführt und die Source/Drain-Bereiche 22 der n-Kanal-Transistoren erzeugt.

Figur 7 : Bei der nach der Arsen-Ionen-Implantation 21 erfolgten thermischen Oxidation, bei der auch die Source/Drain-Bereiche 22 der n-Kanal-Transistoren eingetrieben werden, wird eine weitere Fotolackstruktur 25 erzeugt, die eine ausreichende Maskierung bei der noch folgenden Bor-Implantation 23 zur Erzeugung der p-Kanal-Transistoren gewährleistet. Die Bor-Ionen-Implantation 23 zur Erzeugung der Source/Drain-Bereiche der p-Kanal-Transistoren in der n-Wanne 8 wird mit einer Dosis und Energie von $4 \times 10^{15}$ cm$^{-2}$ und 25 keV durchgeführt. Nach dem Eintreiben der implantierten Boratome entstehen die Source/Drain-Bereiche 24 der p-Kanal-Transistoren.

Die Erzeugung der Isolationsschicht, der Kontaktlochbereiche und der Metalleiterbahnebene erfolgt nach bekannten Verfahrensschritten der CMOS-Technologie.

Bedingt durch die Verwendung von Tantalsilizid-Gates in Kombination mit einer Gateoxiddicke von 20 nm kann die Einsatzspannung der n- und p-Kanal-Transistoren gleichzeitig durch eine einzige Kanalimplantation eingestellt werden. Die Trennung der n- und p-Wannen in dieser selbstjustierten Prozeßfolge wird erreicht durch die Einstellung der unterschiedlichen Eindringtiefen von n- und p-Wanne. Dadurch konnte der kritische Abstand zwischen $n^+$- und $p^+$-Diffusion von 12 μm auf 6 μm reduziert werden, ohne daß die « latch up »-Anfälligkeit erhöht wird. Bei gleichen Kanallängen wurden um 25 % kürzere Schaltzeiten erzielt (gemessen an 3-input NAND/NOR-Ringoszillatoren).

**Patentansprüche**

1. Verfahren zum Herstellen von hochintegrierten, komplementären MOS-Feldeffekttransistorschaltungen (CMOS-Schaltungen), bei dem für die Aufnahme der n- bzw. p-Kanal-Transistoren der Schaltung in Halbleitersubstrat (1, 2) p- bzw. n-dotierte Wannen (5, 8) erzeugt werden, in welche zur Einstellung der verschiedenen Transistoreinsatzspannungen die entsprechenden Dotierstoffatome durch Ionenimplantationen (6, 9, 10, 16, 21, 23) eingebracht werden, wobei die Maskierung für die einzelnen Ionenimplantationen durch Fotolack- und/oder durch Siliziumoxid- bzw. Siliziumnitrid-Strukturen erfolgt und bei dem die Herstellung der Source/Drain- und Gatebereiche sowie die Erzeugung des Zwischen- und Isolationsoxids und der Leiterbahnebene nach bekannten Verfahrensschritten der MOS-Technologie vorgenommen wird, dadurch gekennzeichnet, daß

a) als Gate-Material (17) ein hochschmelzendes Metall oder ein Metallsilizid verwendet wird, dessen Austrittsarbeitsdifferenz $\varnothing_{MS}$ zu n-Silizium im Vergleich zum bekannten $n^+$-Polysilizium-Gate-Material höher ist, wobei $\varnothing_{MS}$ an die Gateoxiddicke $d_{GOX}$ angepaßt ist,

b) die Gateoxiddicke $d_{GOX}$ (15) auf Werte im Bereich von 10 bis 30 nm eingestellt wird und

c) für p- und n-Kanaltransistoren eine einzige gemeinsame Kanalionenimplantation (16) durchgeführt wird, die so abgestimmt ist, daß bei gegebener Gateoxiddicke $d_{GOX}$ (15) die Einsatzspannungen in n- und p-Kanaltransistoren symmetrisch sind und einen vorgegebenen Wert haben.

2. Verfahren nach Anspruch 1, dadurch gekennzeichnet, daß als Gatematerial (17) die Silizide der Metalle Tantal, Titan, Molybdän oder Wolfram verwendet werden.

3. Verfahren zum Herstellen einer CMOS-Schaltung nach Anspruch 1, bei dem von n-dotiertem Siliziumgrundmaterial (1, 2) ausgegangen und Tantalsilizid als Gatematerial (17) verwendet wird, gekennzeichnet durch den Ablauf folgender Verfahrensschritte :

a) Herstellung der p-Wanne (5) durch eine Bor-Ionen-Implantation (6) im n-dotierten, mit einer Oxidschicht (3) bedeckten Substrat (1, 2) nach erfolgter Maskierung der übrigen Bereiche mit einer Siliziumnitridmaske (4),

b) Durchführung eines lokalen Oxidationsprozesses (7) und Eindiffusion der Bor-Ionen,

c) Ablösen der Siliziumnitridmaskierung (4),

d) Herstellung der n-Wanne (8) durch eine Phosphor-Ionen-Implantation (9) und anschließender Eindiffusion der Phosphor-Ionen,

e) Durchführung der Feldimplantation (10) für die n-Kanal-Transistoren im Bereich der p-Wanne (5) nach Maskierung der n-Wanne (8) mittels einer Siliziumnitrid (11)- und Fotolackschicht (12) und des gesamten Transistorbereiches der n-Kanal-Transistoren in der p-Wanne (5) mit einer Siliziumnitridschicht (11),

f) Herstellung der Feldoxidbereiche (14) mittels lokaler Oxidation unter Verwendung der Siliziumnitridschicht (11) als Maskierung,

g) thermische Oxidation der gesamten Oberfläche nach Ablösung der Siliziumnitridmaskierung (11) bis zu einer Gateoxiddicke $d_{GOX}$ (15) von 20 nm,

h) ganzflächige Bor-Ionen-Implantation (16) zur Dotierung des p- und des n-Kanals mit einer Dosis von $1-4 \times 10^{11}$ cm$^{-2}$ und einer Energie von 5-60 keV,

i) Abscheidung und Strukturierung von Tantalsilizid zur Bildung der Gatebereiche (17),

j) ganzflächige Abscheidung einer Oxidschicht (18) in der Dicke, daß die späteren Source/Drain-Implantationen (21, 23) der n- und p-Kanal-Transistoren nicht maskiert werden,

k) Durchführung einer Fotolacktechnik (20), wobei alle Bereiche außer den p-Wannenbereichen (5) mit Fotolack bedeckt bleiben,

l) Durchführung einer Arsen-Ionen-Implantation (21) zur Erzeugung der Source/Drain-Bereiche (22) der n-Kanal-Transistoren und Ablösen der Fotolackstrukturen (20),

m) Durchführung einer weiteren Fotolacktechnik (25), wobei alle Bereiche außer den n-Wannenbereichen (8) mit Fotolack bedeckt bleiben,

n) Durchführung einer Bor-Ionen-Implantation (23) zur Erzeugung der Source/Drain-Bereiche (24) der p-Kanal-Transistoren und Ablösen der Fotolackstrukturen (25) und

o) Erzeugung der Isolationsschicht, der Kontaktlochbereiche und der Metalleiterbahnstrukturebene in bekannter Weise.

4. Verfahren nach Anspruch 3, dadurch gekennzeichnet, daß als Substrat (1) n-dotiertes, in (100)-Richtung orientiertes Silizium von 20 Ohm cm oder eine solche epitaxiale Schicht (2) auf einem $n^+$-dotierten Siliziumsubstrat (1) von 0,01 bis 0,02 Ohm cm verwendet wird.

5. Verfahren nach Anspruch 3 und/oder 4, dadurch gekennzeichnet, daß die Bor-Ionen-Implantation (6) nach Verfahrensschritt a) mit einer Dosis von $1,5 \times 10^{12}$ cm$^{-2}$ und einer Energie von 160 keV und die Phosphorionenimplantation (9) nach Verfahrensschritt e) mit einer Dosis von $7 \times 10^{11}$ cm$^{-2}$ und einer Energie von 160 keV durchgeführt wird.

**Claims**

1. A process for the production of highly integrated, complementary MOS-field effect transistor circuits (CMOS circuits) wherein, for the accommodation of the n- and p-channel transistors of the circuit, in the semiconductor substrate (1, 2) p- and n-doped troughs (5, 8) are formed into which, for the setting of the various transistor starting voltages, the corresponding dopant atoms are introduced by ion implantation steps (6, 9, 10, 16, 21, 23), wherein the masking for the individual ion implantation steps is provided by photo-resist structures and/or silicon oxide or silicon nitride structures, and where the formation of the source/drain zones and gate zones and the formation of the intermediate- and insulating oxide layers and of the conductor path level is carried out in accordance with known MOS process steps, characterised in that

a) the gate material (17) consists of a high-melting point metal or a metal silicide, whose work function difference $\emptyset_{MS}$ to n-silicon is higher than in the case of known n$^+$-polysilicon gate material, where $\emptyset_{MS}$ is adapted to the gate oxide thickness d$_{GOX}$,

b) the gate oxide thickness d$_{GOX}$ (15) is set at values in the range of from 10 to 30 nm, and

c) for p- and n-channel transistors a single common channel ion implantation step (16) is carried out which is arranged to be such that at a given gate oxide thickness d$_{GOX}$ (15), the starting voltages in the n- and p-channel transistors are symmetrical and have a predetermined value.

2. A process as claimed in Claim 1, characterised in that the silicides of the metals tantalum, titanium, molybdenum, or tungsten are used as gate material (17).

3. A process for the production of a CMOS-circuit as claimed in Claim 1, in which p-doped basic silicon material (1, 2) is used and tantalum silicide is used as gate material (17), characterised by the sequence of the following process steps :

a) formation of the p-trough (5) in the n-doped substrate (1, 2), which is covered by an oxide layer (3), by a boron ion implantation step (6), following the masking of the other zones with a silicon nitride mask (4),

b) carrying out of a local oxidation step (7) and diffusing-in of the boron ions,

c) removal of the silicon nitride mask (4),

d) formation of the n-trough (8) by a phosphorus ion implantation step (9) and subsequent diffusing-in of the phosphorus ions,

e) carrying out of the field implantation step (10) for the n-channel transistors in the region of the p-trough (5), following the masking of the n-trough (8) by a silicon nitride layer (11) and a photo-resist layer (12) and of the entire transistor region of the n-channel transistors in the p-trough (5) by a silicon nitride layer (11),

f) formation of the field oxide zones (14) by local oxidation using the silicon nitride layer (11) as mask,

g) thermal oxidation of the entire surface after the removal of the silicon nitride mask (11), to a gate oxide thickness d$_{GOX}$ (15) of 20 nm,

h) a whole-surface boron ion implantation step (16) for the doping of the p- and n-channel with a dose of $1\text{-}4 \times 10^{11}$ cm$^{-2}$ and an energy of 5-60 keV,

i) deposition and structuring of tantalum silicide to form the gate zones (17),

j) whole-surface deposition of an oxide layer (18) in a thickness which is such that the later source/drain implantation steps (21, 23) for the n- and p-channel transistors are not masked,

k) carrying out of a photo-resist step (20), where all the zones, except for the p-trough zones (5), remain covered with photo-resist,

l) carrying out of an arsenic ion implantation step (21) to form the source/drain zones (22) of the n-channel transistors and removal of the photo-resist structures (20),

m) carrying out of a further photo-resist step (25), where all the zones, except for the n-trough zones (8), remain covered by photo-resist,

n) carrying out of a boron ion implantation step (23) to form the source/drain zones (24) of the p-channel transistors and removal of the photo-resist structures (25), and

o) formation of the insulating layer, the contact hole zones and the metal conductor path structure level in a manner known per se.

4. A process as claimed in Claim 3, characterised in that the substrate (1) consists of n-doped silicon orientated in the (100)-direction of 20 Ohm. cm, or an epitaxial layer (2) of this type on a n$^+$-doped silicon substrate (1) of 0.01 to 0.02 Ohm. cm.

5. A process as claimed in Claim 3 and/or 4, characterised in that the boron ion implantation step (6) in accordance with process step a) is carried out at a dose of $1.5 \times 10^{12}$ cm$^{-2}$ and an energy of 160 keV, and the phosphorus ion implantation step (9) in accordance with process step e) is carried out at a dose of $7 \times 10^{11}$ cm$^{-2}$ and an energy of 160 keV.

**Revendications**

1. Procédé pour fabriquer des circuits à transistors à effet de champ MOS complémentaires (circuits CMOS) à haute densité d'intégration, selon lequel pour loger les transistors à canal n ou p du circuit on aménage, dans le substrat semiconducteur (1, 2) des cuvettes (5, 8) dopées du type p ou n et dans lesquelles, afin de régler les différentes tensions de déclenchement des transistors, on insère des atomes correspondants d'une substance dopante, au moyen d'implantations ioniques (6, 9, 10, 16, 21, 23), auquel cas on réalise le masquage pour les différentes implantations ioniques, au moyen de structures formées d'une laque photosensible et/ou de structures formées d'oxyde de silicium ou de nitrure de silicium, et selon lequel on réalise la fabrication des régions de source/drain et de grille ainsi que la production de l'oxyde intermédiaire et de l'oxyde isolant et du plan des voies conductrices, conformément à des étapes opératoires connues de la technologie MOS, caractérisé en ce que

a) comme matériau de grille (17) on utilise un métal à point de fusion élevé ou un siliciure métallique, dont la différence du travail d'extraction $\varnothing_{MS}$ pour le silicium de type n est plus élevée que pour le matériau de grille connu formé de polysilicium de type $n^+$, $\varnothing_{MS}$ étant adapté à l'épaisseur $d_{GOX}$ de l'oxyde de grille,

b) l'épaisseur $d_{GOX}$ (15) de l'oxyde de grille est réglée sur des valeurs situées dans la gamme comprise entre 10 et 30 nm, et

c) pour des transistors à canal p et à canal n on utilise une seule implantation commune (16) d'ions de canal, qui est réglée de manière que, pour une épaisseur donnée $d_{GOX}$ (15) de l'oxyde de grille, les tensions de déclenchement dans les transistors à canal n et p sont symétriques et possèdent une valeur prédéterminée.

2. Procédé suivant la revendication 1, caractérisé par le fait qu'on utilise, comme matériau de grille (17), les siliciures des métaux : tantale, titane, molybdène ou tungstène.

3. Procédé pour fabriquer un circuit CMOS suivant la revendication 1, selon lequel on part d'un matériau de base (1, 2) constitué par du silicium dopé du type n et on utilise du siliciure de tantale en tant que matériau de grille (17), caractérisé par la mise en œuvre des étapes opératoires suivantes :

a) fabrication de la cuvette (5) de type p au moyen d'une implantation (6) d'ions de bore dans le substrat (1, 2) dopé de type n, recouvert par une couche d'oxyde (3), après masquage des autres zones par un masque de nitrure de silicium (4),

b) mise en œuvre d'un procédé d'oxydation locale (7) et pénétration des ions de bore par diffusion,

c) élimination du masque de nitrure de silicium (4) par dissolution,

d) fabrication de la cuvette (8) de type n au moyen d'une implantation d'ions de phosphore (9) et d'une diffusion ultérieure des ions de phosphore,

e) mise en œuvre de l'implantation de champ (10) pour les transistors à canal n dans la région de la cuvette (5) de type p après masquage de la cuvette (8) de type n au moyen d'une couche (11) de nitrure de silicium et d'une couche (12) de laque photosensible et masquage de l'ensemble de la région des transistors à canal n dans la cuvette (5) de type p, par une couche de nitrure de silicium (11),

f) fabrication des régions d'oxyde de champ (14) au moyen d'une oxydation locale moyennant l'utilisation de la couche de nitrure de silicium (11) en tant que masque,

g) oxydation thermique de l'ensemble de la surface après élimination du masque de nitrure de silicium (11) par dissolution, jusqu'à l'obtention d'une épaisseur $d_{GOX}$ (15) de l'oxyde de grille égale à 20 nm,

h) implantation (16) d'ions de bore, sur toute la surface, pour réaliser le dopage du canal de type p et du canal de type n avec une dose de $1\text{-}4 \times 10$ cm$^{-2}$ et une énergie de 5-60 keV,

i) dépôt et structuration du siliciure de tantale pour former les régions de grille (17),

j) dépôt, sur toute la surface, d'une couche d'oxyde (18) sur une épaisseur telle que les implantations ultérieures (21, 23) des sources/drains des transistors à canal n et à canal p ne sont pas masquées,

k) mise en œuvre d'une technique (20) utilisant une laque photosensible, toutes les régions à l'extérieur de la région (5) des cuvettes de type p restant recouvertes par la laque photosensible,

l) mise en œuvre d'une implantation (21) d'ions d'arsenic en vue de la production des régions de source/drain (22) des transistors à canal n et élimination des structures de laque photosensible (20) par dissolution,

m) mise en œuvre d'une autre technique (25) utilisant une laque photosensible, toutes les régions situées à l'extérieur des régions (8) en forme de cuvettes de type n restant recouvertes par une laque photosensible,

n) mise en œuvre d'une implantation (23) d'ions de bore pour la production des régions de source/drain (24) des transistors à canal p et élimination des structures de laque photosensible (25) par dissolution, et

o) production de la couche isolante, des régions des trous de contact et du plan des structures des voies conductrices métalliques, de façon connue.

4. Procédé suivant la revendication 3, caractérisé par le fait qu'on utilise, comme substrat (1), du silicium dopé de type n, possédant l'orientation (100) et une caractéristique de 20 ohms. cm ou une telle couche épitaxiale (2) située sur un substrat en silicium (1) dopé de type $n^+$ et ayant une caractéristique de 0,01 à 0,02 ohm. cm.

5. Procédé suivant la revendication 3 et/ou 4, caractérisé par le fait que l'implantation (6) d'ions de bore lors de l'étape opératoire (a) s'effectue avec une dose de $1,5 \times 10^{12}$ cm$^{-2}$ et avec une énergie de 160 keV et que l'implantation (9) d'ions de phosphore lors de l'étape opératoire (e) s'effectue avec une dose égale à $7 \times 10^{11}$ cm$^{-2}$ et une énergie égale à 160 keV.

## FIG 1

## FIG 2

## FIG 3

## FIG 4

# FIG 5

16

B⁺

8  15  14  15  5  14

n

p  p

n⁻  p⁻

n⁺

1  2

# FIG 6

21

As⁺

8  17  20  17  18  22  20

22

n  p  p

n⁻  p⁻

n⁺

1  2  5

# FIG 7

23

B⁺

22  17  18  25

8  24  17  24  22

n  p  p

n⁻  p⁻

n⁺

1  2  5